# EUROPÄISCHE PATENTSCHRIFT

(11) **EP 1 747 835 B1**
(45) Veröffentlichungstag und Bekanntmachung des Hinweises auf die Patenterteilung: **19.03.2008**
(21) Anmeldenummer: 05106921.9
(22) Anmeldetag: 27.07.2005
(51) Int. Cl.: B23K 1/005, G02B 7/00

(54) **Verfahren zur hochpräzisen Befestigung eines miniaturisierten Bauteils auf einer Trägerplatte**
Method for fixing miniaturised components onto a base plate by soldering with high precision
Procédé de fixation haute precision par brasage de composants miniaturises sur une platine

(43) Veröffentlichungstag der Anmeldung: 31.01.2007
(73) Patentinhaber: Leica Geosystems AG, 9435 Heerbrugg (CH)
(72) Erfinder: Stauffer, Laurent, 9443 Widnau (CH); Kipfer, Peter, Dr., 9437 Marbach (CH); Bernhard, Heinz, 9442 Berneck (CH)
(74) Vertreter: Büchel, Kaminski & Partner

(56) Entgegenhaltungen:
- EP-A- 0 758 145
- WO-A-99/26754
- WO-A-20/04050287

## Beschreibung

Die vorliegende Erfindung betrifft ein Verfahren zur hochpräzisen Befestigung eines miniaturisierten Bauteils auf einem vorgegebenen Befestigungsabschnitt einer Trägerplatte mittels einer Lötverbindung.

Unterschiedliche Verfahren zum Befestigen miniaturisierter Bauteile mittels einer Lötverbindung sind aus dem Stand der Technik bekannt.

In der WO 99/26754 wird ein Verfahren zur Lötbefestigung miniaturisierter Bauteile auf einem planen Substrat, das beispielsweise von einer Saphirplatte oder einer Pyrex-, Quarz- oder Zerodur-Platte gebildet wird, beschrieben. Die Substratplatte wird zumindest teilweise mit einem gitterförmigen Metallmuster bzw. einer Metallstruktur beschichtet. Gemäss der WO 99/26754 ist die Musterstruktur aus einem Gitter aus Flächenelementen oder einer Reihe von sich bevorzugt senkrecht schneidenden Streifen zusammengesetzt, die ein Gitter oder sonst irgendeine Struktur bilden, die durch einen gleichförmigen Wechsel von Metallbereichen und freien Bereichen gekennzeichnet ist. Die Flächenelemente können eine rechteckige Form, eine quadratische Form, eine runde Form oder irgendeine Form annehmen, die geeignet ist, bei diesem Verfahren verwendet zu werden. Die Musterschrittweite sollte hierbei wenigstens eine Grössenordnung kleiner sein als die Abmessungen der zu befestigenden Seite des Bauteils. Das Lötmaterial wird auf der zu befestigenden, insbesondere konvexen Seite aus Metall des Bauteils aufgebracht. Das Bauteil wird oberhalb der Substratplatte angeordnet, wobei sich das plane Metallmuster und die Lötmaterialschicht des Bauteils in berührungsfreier, vertikal beabstandeter Gegenüberlage befinden. Dann wird Wärmeenergie - insbesondere Laserstrahlung - von der unbeschichteten Seite der ebenen Substratplatte zum Schmelzen von Lötmaterial der Lötmaterialschicht auf der beschichteten Seite, auf der auch das Bauteil angeordnet ist, bis zu einer Tropfenbildung des Lötmaterials zugeführt, wodurch der Lötmaterialtropfen den Zwischenraum zwischen dem Bauteil und der Substratplatte zur gegenseitigen Befestigung füllt. Die metallisierten Musterbereiche liefern einen Befestigungsbereich für das Lötmaterial, während es die metallfreien Bereiche ermöglichen, dass eine ausreichende Energiemenge durch die Substratplatte hindurchgehen kann, um das Lötmaterial direkt zum Schmelzen zu bringen. Beim Zuführen der Wärmeenergie geht somit ein Teil der Energie durch die unbeschichteten Bereiche des Metallmusters. Derjenige Teil, der auf die mit Metall beschichteten Bereiche des Metallmusters gelangt, erwärmt entweder die Metallschicht oder wird reflektiert. Die Energie wird vorzugsweise mittels eines Laserstrahls aufgebracht. Aufgrund der Gitterstruktur des Metallmusters auf der Substratplatte kommt der Wahl eines geeigneten Lichtabsorptionskoeffizienten der Metallschicht eine besondere Bedeutung zu, da einerseits die Substratplatte nicht überhitzen darf, andererseits eine gewisse Mindesttemperatur zur Durchführung des Prozesses erforderlich ist. Üblicherweise werden bei dem in der WO 99/26754 beschriebenen Verfahren von dem Metallmuster etwa 70% der Oberfläche der ebenen Substratplatte mit Metall abgedeckt. In der Praxis hat sich ergeben, dass das Lötmaterial nahe den Querseiten des Bauteils wesentlich schneller abkühlt als der Rest des Lötmaterials. Dies kann zu Asymmetrien des erstarrten Lötmaterials führen. Da bei der Befestigung durch das Löten mehrere unterschiedliche Materialien aneinandergrenzen, können unterschiedliche Wärmeausdehnungskoeffizienten der ebenen Substratplatte, der darauf befindlichen Metallschicht, des Lötmaterials und des Bauteils hohe Spannungen und Verzüge nach Durchführung des Lötverfahrens verursachen. Aufgrund der unterschiedlichen Materialien auf Unter- und Oberseite unvermeidbare Temperaturdifferenzen zwischen den unteren und oberen Seiten der Substratplatte können sogar zu einem Aufwölben der ebenen Substratplatte führen, wodurch die Positionierungsgenauigkeit verschlechtert wird. Abhängig vom mechanischen Widerstand des Trägermaterials kann eine parasitäre örtliche Verformung im Bereich der Lötverbindung aufgrund der hohen Spannungen entstehen. Ein weiteres Problem stellt der relativ komplexe Aufbau der Substratplatte dar, da mittels eines verhältnismässig aufwendigen Verfahrens das plane Substrat, das beispielsweise von einer Saphirplatte oder einer Pyrex-, Quarz- oder Zerodur-Platte gebildet wird, mit dem gitterförmigen Metallmuster bzw. der Metallstruktur beschichtet werden muss. Eine freie Positionierbarkeit des Bauteils ist bei dem bekannten Verfahren aufgrund des Vorhandenseins metallfreier Bereiche nur bedingt, vor allem in diskreten Schritten auf der Musterstruktur, möglich. Durch das oben beschriebene, bekannte Verfahren sind Genauigkeiten von etwa 2 Mikron in den 6 Freiheitsgraden erzielbar. Vor allem für die Montage von Bauteilen, die mikrooptische Elemente beinhalten oder tragen, sind jedoch noch höhere Montagegenauigkeiten erforderlich. Positionierungsgenauigkeiten von unter 1 Mikron bzw. 0,1 mrad werden zumindest angestrebt.

Eine Lösung zur Verbesserung des in der WO 99/26754 offenbarten Verfahrens wird in der WO 2004/050287 A1 derselben Anmelderin beschrieben. Bei diesem Verfahren ist die Metallschicht auf der ebenen Substratplatte flächig stetig in Form einer unterbrechungsfreien Schicht aufgebracht. Direkt auf dieser Metallschicht befindet sich eine weitere entweder ebenfalls unterbrechungsfreie oder musterartige Schicht aus Lötmaterial. Die Metallschicht wird in einem lokal begrenzten Bereich - beispielsweise mittels eines Laserstrahlenbündels - von der Unterseite der für Laserstrahlung im Wesentlichen transparenten Substratplatte durch Absorption der Laserstrahlung erhitzt. Hierdurch wirkt die Metallschicht wie eine Herdplatte, so dass das darauf angeordnete Lötmaterial schmilzt und in bekannter Weise durch Tropfenbildung den Zwischenraum zwischen der Metallschicht und dem Bauteil zur gegenseitigen Befestigung füllt. Ein Vorteil dieses Verfahrens besteht darin, dass aufgrund der kontinuierlichen, stetig flächigen Metallschicht, verglichen zu dem zuvor bekannten Metallmuster-Verfahren, eine wesentlich höhere EndPositionierungsgenauigkeit des Bauteils auf der SubstratPlatte erreicht wird, da die durchgehende Metallfläche wesentlich einfacher und homogener mit dem Lötmaterial benetzt wird, als dies bei einer unterbrochenen Metallmusterschicht der Fall ist. Mit dem beschriebenen Lötverfahren werden angeblich Befestigungsgenauigkeiten im Bereich von 0,25 Mikron erreicht, so dass dieses Verfahren zur hochpräzisen Montage von mikrooptischen Komponenten auf einer Substratplatte verwendet werden kann.

Die beiden Verfahren aus der WO 99/26754 und der WO 2004/050287 A1 eignen sich vor allem zur Anwendung in einem automatischen, flussmittelfreien Laserlötprozess, da im Wesentlichen alle erforderlichen Schritte von Handhabungsrobotern, die über eine hochgenaue Positionssensorik verfügen, durchgeführt werden können. So kann jedes Bauteil frei im Raum hochpräzise in allen 6 Freiheitsgraden positioniert werden. Ist die gesamte Substratplatte mit der planen Metallschicht beschichtet, so besteht die Möglichkeit, entweder durch freies Positionieren eines Lötmaterialflachstücks oder im Falle einer Lötmaterialschicht das Bauteil in einer beliebigen Position auf der ebenen Substratplatte zu positionieren. Das miniaturisierte Bauteil kann beispielsweise als Halterung für ein mikrooptisches Element, z.B. eine Linse, eine optischen Faser, eine Laserdiode, etc., dienen. Solche mikrooptischen Bauteile haben typischerweise einen Durchmesser in der Grössenordnung von 2 mm und eine Höhe von 3 mm. Ein mögliches Beispiel einer Haltevorrichtung für ein mikrooptisches Bauteil ist der EP 1127287 B1 zu entnehmen.

Zahlreiche weitere Verfahren zur Befestigung kleiner Bauteile auf einer Trägerplatte sind aus dem Bereich der Bestückungstechnik elektronischer oberflächenmontierter Schaltungen, der SMD-Technik, bekannt. Bei elektronischen Schaltungen bestehen jedoch vollkommen andere Anforderungen als im Bereich der Montage mikrooptischer Bauteile, da bei elektronischen Schaltungen geringere Präzisionen erforderlich sind und keine hochgenaue Ausrichtung in allen 6 Freiheitsgraden erforderlich ist. Ausserdem müssen elektronische Schaltungen definitionsgemäss auf unterbrochenen Metallschichten aufgebaut sein, da die Montage einer Vielzahl von elektronischen Bauteilen auf einer Leiterplatte mit einer einzigen ununterbrochenen Metallschicht unzweckmässig wäre. Die hoch präzise Ausrichtbarkeit von Bauteilen auf einer Trägerplatte ist bei elektronischen Schaltungen weder erforderlich, noch gewünscht, jedoch beispielsweise für den Aufbau eines mikrooptischen Systems auf einer Trägerplatte von entscheidender Bedeutung. Somit eignen sich Ansätze aus der elektronischen Leiterplatten-Bestückungstechnik nur bedingt.

Aufgrund der zumindest teilweisen freien Ausrichtbarkeit der Bauteile in möglicherweise allen 6 Freiheitsgraden werden hohe Anforderungen an das Positionierungssystem, mittels welchem die Bauteile auf der ebenen Substratplatte positioniert und während des Lötverfahrens gehalten werden, gestellt.

In der WO 2004/052070 A1 ebenfalls derselben Anmelderin wird ein Verfahren, eine Vorrichtung und ein System zum hochgenauen Fixieren eines miniaturisierten - insbesondere mindestens ein optisches Element tragenden oder enthaltenden - Bauteils auf einer ebenen Trägerplatte durch eine Löt-, Schweiss- oder Klebeverbindung beschrieben. Das Bauteil wird mit einem Greifer einer Roboterstation über der Trägerplatte relativ zu äusseren Bezugspunkten positioniert, wobei bevorzugt 5 der 6 Freiheitsgrade der Sollposition des Bauteils hochgenau entsprechen. Der senkrechte Abstand zwischen dem Bauteil und der Trägerplatte ergibt sich aus dem Sollabstand zuzüglich eines Aufmasses, das dem Schrumpfungsgrad der Verbindungsnaht entspricht. Im Anschluss wird eine Verbindung zwischen dem Bauteil und der Trägerplatte hergestellt, wobei eine Verbindungsnaht zwischen dem Bauteil und der Trägerplatte unter Schrumpfung erstarrt und somit eine Zugkraft auf den das Bauteil fassenden Greifer in senkrechter Richtung ausübt. Gleichzeitig mit der Schrumpfung führt der Greifer eine gesteuerte oder geregelte senkrechte Bewegung in Richtung zur Trägerplatte - gegebenenfalls bis zu einer vertikalen definierten Sollposition - aus und gibt somit der Schrumpfung aktiv nach, so dass der Aufbau von hohen Spannungen weitgehend verhindert wird und beim Lösen des Bauteils vom Greifer keine Positionsänderung ausgelöst wird. Der Greifer vollzieht waagrecht zur Trägerplatte keine Positionsänderung während des Erstarrungsprozesses. Weiters wird ein Greifer zur Verwendung in dem Verfahren beschrieben.

Die bisher aus dem Stand der Technik bekannten Verfahren zur hochpräzisen Lötbefestigung miniaturisierter Bauteile auf einer planen Substratplatte weisen mehrere Schwachpunkte auf, die bisher nicht hinreichend gelöst werden konnten. Unterschiedliche Wärmeausdehnungskoeffizienten zwischen der Substratplatte und dem Lotmaterial sowie dem Lötmaterial und dem Bauteil führen zu dauerhaften mechanischen Spannungen. Die geringe Zugfestigkeit der Substratplatte, insbesondere des hauptsächlich verwendeten Pyrex, führt zum Teil mit den Lötlegierungen SnAg und AuSn zur Bildung von Rissen während des Lötprozesses oder im Laufe der Lebensdauer des Produkts. Unterschiedliche Temperaturen zwischen der oberen und der unteren Seite der Substratplatte verursachen ein bimetallartiges Verbiegen der Substratplatte, was vor allem beim Aufbau komplexer Miniaturoptiken auf der Substratplatte höchst problematisch ist. Die hohen Kosten einer geeigneten Substratplatte, die insbesondere aus Saphir, Pyrex, Quarz oder Zerodur besteht, und die schlechte spanende oder spanlose Bearbeitbarkeit dieser Werkstoffe wirken sich nachteilig auf die Wirtschaftlichkeit der bekannten Verfahren aus. Das spröde Verhalten der für die Substratplatte geeigneten Werkstoffe hat zur Folge, dass fertig bestückte Substratplatten mittels Klebung im Endgehäuse zu befestigen sind, da spanende Arbeiten, insbesondere Bohren und Sägen, an der Substratplatte nur mittels aufwendiger Bearbeitungstechniken möglich sind. Nicht plattenartige Formgebungen der Substratplatte sind daher kaum realisierbar. Aufgrund der lokal begrenzten Zufuhr von Wärme kommt es insbesondere im Falle einer unterbrechungsfreien Metallschicht zu einer Aufwölbung des erhitzten Bereichs, da dessen Wärmeausdehnung nicht lateral von den sich kaum oder nicht ausdehnenden, kühleren Randbereich kompensiert wird. Dieses Aufwölben führt ebenfalls zu einer Verschlechterung der vertikalen Endpositionierungsgenauigkeit. Aus diesem Grunde wurde in der Fachwelt wieder Abstand von einer durchgehenden Metallschicht genommen, da die lokale Wärmeeinbringung einer durchgehenden Metallschicht entgegensteht. Das nachträgliche Feinausrichten eines befestigten Bauteils gegenüber der Substratplatte ist nur mittels eines entsprechend ausrichtbaren Bauteilhalters möglich.

Aufgabe der vorliegenden Erfindung ist es, ein Verfahren zur über eine Lötverbindung erfolgenden Befestigen eines miniaturisierten, insbesondere ein mikrooptisches Element aufweisenden Bauteils auf einer Trägerplatte zur Verfügung zu stellen, das sich durch eine erhöhte Endpositionsgenauigkeit der Bauteile, höhere Prozesssicherheit, einen möglichst einfachen Aufbau der beteiligten Komponenten und einfache Handhabbarkeit auszeichnet.

Diese Aufgabe wird durch die Merkmale des unabhängigen Anspruchs gelöst. Merkmale, welche die Erfindung in alternativer oder vorteilhafter Weise weiterbilden, sind den abhängigen Ansprüchen zu entnehmen.

Das erfindungsgemässe Verfahren dient zur Befestigung eines miniaturisierten Bauteils auf einem vorgegebenen Befestigungsabschnitt einer Trägerplatte mittels einer Lötverbindung. Als Trägerplatte ist derjenige Träger zu verstehen, auf welchem mindestens ein Bauteil, vorzugsweise mehrere Bauteile, unmittelbar mittels Lot mechanisch zu befestigen ist und welcher eine Struktur besitz, die eine für die Belastungsanforderungen ausreichende Festigkeit aufweist, um das Bauteil in seine Endpositionierung zu halten.

Die Trägerplatte ist erfindungsgemäss durchgängig aus einem metallischen Werkstoff ausgebildet. Als metallischer Werkstoff eignet sich insbesondere eine Legierung wie beispielsweise Stahl, rostfreier Edelstahl, Invar oder Arcap, ein metallischer, löttauglicher Keramikwerkstoff, ein Metall-Verbundwerkstoff oder ein sonstiger metallischer Pulver- oder Sinterwerkstoff, der als Grundwerkstoff zum Löten tauglich ist. Die Dicke der Trägerplatte beträgt vorzugsweise zwischen 0,5 und 2 mm. Der metallische Werkstoff weist einen hohen Absorptionskoeffizienten für die bei dem Verfahren zum Einsatz kommende elektromagnetische Strahlung auf. Bei Verwendung eines Laserstrahlenbündels ist der Werkstoff im Wesentlichen intransparent für Laserstrahlung und besitzt einen hohen Laserstrahlenabsorptionskoeffizienten. Zur Erhöhung der Absorption des Laserstrahlenbündels ist es möglich, die Trägerplatte zumindest im Befestigungsabschnitt auf der Unterseite zu schwärzen, beispielsweise durch Aufbringen einer thermisch beständigen schwarzen Lackschicht. Durch die relativ gute Wärmeleitfähigkeit der durchgängig aus dem metallischen Werkstoff bestehenden Trägerplatte entsteht kein bimetallartiges Verbiegen, da die untere und obere Seite der Trägerplatte sofort die gleiche Temperatur erreichen können. Der mindestens eine Befestigungsabschnitt der Trägerplatte wird von einem Aussparungsbereich in der Trägerplatte, der von mindestens einem Verbindungssteg überbrückt wird, umschlossen. Dieser Aussparungsbereich ist beispielsweise als ein durchgehender senkrechter Schlitz in der Trägerplatte ausgebildet, der den Aussparungsbereich, unterbrochen durch den mindestens einen Verbindungssteg, insbesondere ringartig umschliesst. Der Aussparungsbereich in der Trägerplatte kann beispielsweise vermittels Stanzen, Laserschneiden, Wasserstrahlschneiden, elektroerosiver Metallbearbeitung oder spanend insbesondere durch Fräsen hergestellt werden. Der Befestigungsabschnitt ist vorzugsweise derart dimensioniert und ausgestaltet, dass ein einziges Bauteil auf dem Befestigungsabschnitt befestigbar ist. Der mindestens eine Verbindungssteg ist beispielsweise als ein gerader, auf das Zentrum des Befestigungsabschnitts gerichteter Steg, als ein gekrümmter oder mäanderförmiger Steg oder federartig - insbesondere im Zickzackanordnung - abgeknickt ausgebildet. Der Aussparungsbereich kann eine beliebige, vorzugsweise runde, elliptische, quadratische, polygonale oder freiförmige Grundform besitzen. In einer möglichen Ausführungsform ist der Aussparungsbereich als eine im Wesentlichen ringförmige Aussparung ausgebildet, die von dem mindestens einen Verbindungssteg, vorzugsweise von mehreren - beispielsweise drei - entlang der ringförmigen Aussparung in gleichmässigen Winkelabständen - beispielsweise von 120° - verteilten, radial verlaufenden Verbindungsstegen überbrückt ist. In einer Weiterbildung wird der Aussparungsbereich von mehreren konzentrisch beabstandet angeordneten, ringförmigen Aussparungen gebildet, wobei beispielsweise die in gleichmässigen Winkelabständen verteilten ersten Verbindungsstege einer ersten ringförmigen Aussparung und die in den gleichmässigen Winkelabständen verteilten zweiten Verbindungsstege einer zweiten unmittelbar benachbarten ringförmigen Aussparung um den halben Winkelabstand versetzt angeordnet und über einen die erste ringförmige Aussparung und die zweite ringförmige Aussparung radial trennenden ringförmigen Verbindungssteg verbunden sind. Diese Anordnung bewirkt, dass eine laterale Wärmeausdehnung des Befestigungsabschnitts in seitlicher Richtung durch Verformung des ringförmigen Verbindungsstegs, der federartig wirkt, ausgeglichen wird. Der Aussparungsbereich ist bevorzugt derart ausgebildet, dass entlang dem mittleren - insbesondere kreisförmigen - Umfang des Aussparungsbereichs der von dem mindestens einen Verbindungssteg der Trägerplatte überbrückte Anteil wesentlich geringer als der ausgesparte Anteil ist. Als mittlerer Umfang ist ein gemittelt zentrisch im Aussparungsbereich verlaufender, den mindestens einen Verbindungssteg durchlaufender Umfang zu verstehen. Dies ist beispielsweise im Falle eines ringförmigen Aussparungsbereichs der mittlere Ringumfang. Der von dem mindestens einen Verbinddungssteg überbrückte Anteil beträgt vorzugsweise weniger als 20%, insbesondere weniger als 15% von dem gesamten mittleren Umfang. Die Trägerplatte einschliesslich des Befestigungsabschnitts und des mindestens eines Verbindungsstegs ist bevorzugt einstückig ausgebildet. Es ist jedoch möglich, dass die Trägerplatte und der Befestigungsabschnitt aus getrennten Teilen bestehen, die gegebenenfalls aus unterschiedlichen Werkstoffen hergestellt sind und mittels mindestens eines Verbindungsstegs miteinander gekoppelt werden.

Diese erfindungsgemässe Ausgestaltung bewirkt insbesondere, dass die Wärmeleitung von dem Befestigungsabschnitt, dessen Abmessungen auf die der Basis des Bauteils begrenzt sein können, auf die restliche Trägerplatte auf ein Minimum reduziert werden kann. Der mindestens eine Verbindungssteg koppelt den Befestigungsabschnitt mechanisch mit der restlichen Trägerplatte, ohne einen allzu grossen Wärmeübergang zu schaffen. Somit kann erreicht werden, dass durch Aufbringen einer relativ geringen Energiemenge lediglich der als Erhitzungsfläche für das Lötmaterial dienende Befestigungsabschnitt der Trägerplatte erhitzt wird, ohne hierbei den restlichen Anteil der Trägerplatte allzu sehr aufzuwärmen. Durch die relativ hohe Wärmeleitfähigkeit des metallischen Werkstoffs lässt sich der Befestigungsabschnitt schnell und gleichmässig erwärmen. Hierdurch wird eine homogene Benetzbarkeit mit Lötmaterial erreicht. Ein weiterer Vorteil besteht darin, dass der mindestens eine Verbindungssteg derart ausgestaltbar ist, dass er in seitliche Richtung nachgiebig federartig wirkt, so dass eine laterale Wärmeausdehnung des Befestigungsabschnitts beim Zuführen der elektromagnetische Strahlung sowohl von dem Aussparungsbereich, als auch von dem mindestens einen nachgiebigen Verbindungssteg kompensiert wird und sich nicht auf den restlichen, nicht erwärmten Teil der Trägerplatte auswirkt. Durch eine ferderartige Schlitz- und Verbindungsstegstruktur lässt sich das im Stand der Technik höchst problematische Aufwölben aufgrund lokaler Wärmeausdehnung mittels eines Ausgleichs thermischer Spannungen in der Trägerplatte vermeiden.

Da die Trägerplatte aus einem metallischen Werkstoff besteht, lässt sich ein Werkstoff wählen, der sich leicht mittels spanender oder spanloser Verfahren bearbeiten lässt, z.B. Stahl, so dass beispielsweise Bohrungen für Befestigungsschrauben oder zur Montage von zusätzlichen Bauteilen problemlos möglich sind. Ebenfalls ist es möglich, der Trägerplatte mittels Umformung, insbesondere Tiefziehen, eine beliebige dreidimensionale Form zu verleihen. Daher sei unter einer Trägerplatte auch ein nicht ebener - beispielsweise gewölbter - Körper zu verstehen. Ebenfalls ist es möglich, durch plastische Verformung des mindestens einen Verbindungsstegs den Befestigungsabschnitt einschliesslich eines allfällig bereits befestigten Bauteils relativ zur restlichen Trägerplatte auszurichten, ohne dass dies eines - wie aus dem Stand der Technik bekannten - ausrichtbaren Bauteilhalters bedarf.

Für die Erläuterung des Verfahrens wird die Oberseite der Trägerplatte als die Bezugsebene und die zum Bauteil hingewandte Seite definiert, so dass als die Vertikale oder die Lotrechte eine Normale zur Trägerplatte und als die Horizontale, die Waagrechte oder die seitliche Richtung eine Richtung oder Ebene parallel zur Oberseite der Trägerplatte zu verstehen seien. Entsprechendes gilt für Begriffe wie "oberhalb" oder "unterhalb". Denn selbstverständlich ist es möglich, das beschrieben Verfahren nicht nur wie dargestellt an einer horizontal ausgerichteten Trägerplatte, sondern auch an einer schräg, über Kopf oder auf sonstige Weise ausgerichteten Trägerplatte durchzuführen. Daher seien die Oberseite und Unterseite der Trägerplatte nicht auf ein absolutes übergeordnetes Bezugssystem bezogen. Die Unterseite der Trägerplatte sei die vom Bauteil weggewandte Seite.

Als die Basis des Bauteils sei derjenige Abschnitt des Bauteils zu verstehen, der zumindest teilweise von dem geschmolzenen Lötmaterial im Rahmen des Verfahrens benetzt wird und somit zur Befestigung auf der Trägerplatte beiträgt. Das Bauteil oder zumindest die Basis kann insbesondere aus einem metallischen Werkstoff, wie aus dem Stand der Technik bekannt, oder aus metallischer Keramik bestehen. Diese Basis kann, wie beispielsweise aus der EP 1127287 B1, der WO 99/26754 und der WO 2004/050287 A1 bekannt, eine Zylindermantelflächenform oder Kugelsegmentform aufweisen. Sehr gute Ergebnisse werden erzielt, wenn der Werkstoff des Bauteils oder der Basis dem der Trägerplatte gleicht.

Auf der Oberseite des Befestigungsabschnitts der Trägerplatte ist zumindest teilweise Lötmaterial, beispielsweise in Form eines im Zentrum des Befestigungsabschnitts lose auf der Oberfläche horizontal verschiebbar positionierten Lötmaterialflachstücks, einer im Befestigungsabschnitts unterbrechungsfrei oder musterartig aufgebrachten Lötmaterialschicht oder in sonstiger Weise aufgebracht.

Als Lötmaterial eignen sich insbesondere aus dem Stand der Technik bekannte Zinnlegierungen, beispielsweise flussmittelloses Lötmaterial aus Sn96Ag4.

In einer Weiterbildung der Erfindung weist die Basis des Bauteils die Form eines nach unten offenen Hohlzylinders - insbesondere eines geraden Kreishohlzylinders - auf, dessen Zylinderachse lotrecht zur Trägerplatte verläuft. Die Zylinderwand ist dünnwandig ausgebildet, um die Wärmeleitung von dem geschmolzenen heissen Lötmaterial auf das Bauteil, insbesondere auf ein allfälliges dort angeordnetes mikrooptisches Element, möglichst gering zu halten. Das auf der Oberseite des Befestigungsabschnitts aufgebrachte, noch nicht geschmolzene Lötmaterial ist hier als ein Lötmaterialflachstück, das die Grundform eines flachen Zylinderstumpfs aufweist, ausgebildet und auf dem Befestigungsabschnitt horizontal verschiebbar angeordnet. Der Lötmaterialaussendurchmesser ist kleiner als der Hohlzylinderinnendurchmesser.

In einem ersten Schritt des Verfahrens zur hochpräzisen Befestigung des miniaturisierten Bauteils, insbesondere mit einem mikrooptischen Element, auf einem vorgegebenen Befestigungsabschnitt einer Trägerplatte durch eine Lötverbindung erfolgt ein hochpräzises Anordnen des Bauteils oberhalb des Befestigungsabschnitts, wobei sich das Lötmaterial und die Basis des Bauteils in berührungsfreier, - insbesondere vertikal - beabstandeter, einen Zwischenraum bildenden Gegenüberlage befinden. In der oben beschriebenen Weiterbildung der Erfindung, in welcher die Basis des Bauteils die Form eines nach unten offenen Hohlzylinders aufweist, umfasst dieser Verfahrensschritt in einem ersten Teilschritt das Anordnen des Bauteils oberhalb des Befestigungsabschnitts, wobei das Lötmaterial von der hohlzylindrischen Basis in berührungsfreier, beabstandeter, einen Zwischenraum bildenden Gegenüberlage umschlossen wird, und in einem zweiten Teilschritt das hochpräzise horizontale Feinpositionieren des Bauteils, wobei die hohlzylindrische Basis das eingeschlossene Lötmaterial horizontal mitschiebt. Dieser letztgenannte Teilschritt umfasst in einer weiteren Weiterbildung der Erfindung einen ersten Unterschritt des horizontalen Lötmaterial-Feinpositionierens durch Verschieben des eingeschlossenen Lötmaterials durch horizontales Vorpositionieren des Bauteils, wobei die hohlzylindrische Basis das eingeschlossene Lötmaterial horizontal mitschiebt, und einen zweiten Unterschritt des hochpräzisen horizontalen Feinpositionierens des Bauteils. Diese Weiterbildung der Erfindung bewirkt, dass mittels des horizontalen Positionierens des Bauteils über der Trägerplatte ebenfalls das Lötmaterial mitpositioniert werden kann und gegebenenfalls präzise zentrisch zur Basis des Bauteils ausrichtbar ist. Somit kann verhindert werden, dass das unter Schrumpfung erstarrende Lötmaterial die horizontale Ausrichtung des Bauteils beeinflusst, da im Falle einer symmetrischen Anordnung des Bauteils die Schrumpfung im Wesentlichen ausschliesslich eine vertikale Positionsveränderung des Bauteils in Richtung zur Trägerplatte bewirkt, die restlichen 5 Freiheitsgrade jedoch unbeeinflusst bleiben.

In einem zweiten Schritt des Verfahrens erfolgt das Zuführen von elektromagnetischer Strahlung in einem lokal, im Wesentlichen auf den Befestigungsabschnitt beschränkten Bereich von der Unterseite der Trägerplatte, so dass das Lötmaterial zumindest teilweise schmilzt und - bedingt durch seine Oberflächenspannung im verflüssigten Zustand - einen Lötmaterialtropfen bildet. Das ursprünglich flache Lötmaterial nimmt durch die Tropfenbildung somit eine in vertikaler Richtung zur Basis des Bauteils zunehmende Vertikalabmessung an, so dass sich der vertikale Abstand zwischen dem Lötmaterial und dem Bauteil verringert. Gegebenenfalls wird in einem Teilschritt der vertikale Abstand des Bauteils zu der Trägerplatte zusätzlich durch Absenken des Bauteils von der Ausgangsposition in Richtung zur Trägerplatte verringert. Durch die Tropfenbildung und gegebenenfalls auch durch das Absenken des Bauteils füllt sich der Zwischenraum zur gegenseitigen Befestigung mit dem geschmolzenen Lötmaterial, so dass die Basis des Bauteils zumindest teilweise mit dem geschmolzenen Lötmaterial benetzt wird.

Die elektromagnetische Strahlung wird vorzugsweise von einem Laserstrahlenbündel gebildet. In diesem Fall erfolgt das Zuführen der elektromagnetischen Strahlung lokal begrenzt durch Richten des Laserstrahlenbündel auf die Unterseite des Befestigungsabschnitts derart, dass das Laserstrahlenbündel von der Unterseite des Befestigungsabschnitts im Wesentlichen absorbiert wird und den Befestigungsabschnitt derart erhitzt, dass das Lötmaterial auf der Oberseite des Befestigungsabschnitts zumindest teilweise schmilzt. Die Absorption lässt sich erhöhen, indem die Unterseite des Befestigungsabschnitts geschwärzt wird.

In einem dritten Schritt des Verfahrens, in welchem keine elektromagnetische Strahlung mehr zugeführt wird, erfolgt das Warten auf die gegenseitige Befestigung durch Wiedererstarren des geschmolzenen Lötmaterials.

Das Anordnen des Bauteils erfolgt vorzugsweise mittels eines Handhabungssystems, insbesondere eines Greifers. In einer Weiterbildung der Erfindung werden in dem Schritt des Wartens, in welchem das geschmolzene Lötmaterial unter Schrumpfung erstarrt, die durch die Schrumpfung von dem Handhabungssystem auf das Bauteil wirkenden Kräfte, insbesondere mittels eines aktiv oder passiv nachgiebigen Greifers, wie aus der WO 2004/052070 A1 bekannt, im Wesentlichen ausgeglichen.

In einem weiteren optionalen Schritt ist es möglich, den nicht von dem mindestens einen Verbindungssteg überbrückten Aussparungsbereich zumindest teilweise mit einem flüssigen, erstarrenden Füllmaterial zum zumindest teilweisen Überbrücken des Aussparungsbereichs aufzufüllen. Als Füllmaterial eignet sich beispielsweise Klebstoff oder Lot. Hierdurch kann der mechanisch nur über den mindestens einen Verbindungssteg mit der restlichen Trägerplatte verbundene und somit eventuell dauerhaft nicht ausreichend fixierte Befestigungsabschnitt sicher und dauerhaft fixiert werden, so dass eine Depositionierung des Bauteils aufgrund einer ungewollten Bewegung des Befestigungsabschnitts zur restlichen Trägerplatte verhindert wird. Eine durch plastische Verformung der Verbindungsstege ermöglichte Feinausrichtung des Befestigungsabschnitts einschliesslich des dort befestigten Bauteils kann hierdurch dauerhaft fixiert werden.

Die Kombination des Bauteilträgers in Form der Trägerplatte mit dem Lotmaterialträger in Form der Oberfläche aus Metall erschien bisher aufgrund der Erkenntnisse aus dem Stand der Technik als völlig widersinnig, da der Stand der Technik lehrt, einen für die zur Erwärmung verwendete elektromagnetische Strahlung transparenten mechanischen Trägerkörper vorzugsweise in Form einer Pyrexplatte zu verwenden und hierauf eine möglichst dünne Metallschicht, deren einzige Funktion in der Benetzbarkeit mit Lötmaterial liegt, aufzubringen. Die Fachwelt unterlag bisher dem Vorurteil, dass die Kombination eines Lötmaterialträgers mit einem mechanischen Bauteilträger in diesem technischen Gebiet nicht möglich sei, weil durch die lokal begrenzte, sehr hohe Wärmeeinbringung und den entsprechend grossen Temperaturgradienten sehr hohe Spannungen im Träger auftreten, so dass es zu einem Verzug des Trägers kommt und somit hohe Endpositionsgenauigkeiten nicht erzielbar sind. Dieses Vorurteil schienen auch zunächst praktische Versuche mit einer unterbrechungsfrei auf einem Pyrexträger aufgebrachten Metallschicht, wie aus der WO 2004/050287 A1 bekannt, zu bestätigen. Die Erfindung greift jedoch trotz der entgegengesetzten Lehre den Gedanken der Kombination eines Bauteilträgers mit einem Lötmaterialträger wieder auf, wodurch sich überraschenderweise erhebliche Vorteile gegenüber dem Stand der Technik erzielen lassen.

Das erfindungsgemässe Verfahren und die erfindungsgemässe Vorrichtung werden nachfolgend anhand von in den Zeichnungen schematisch dargestellten konkreten Ausführungsbeispielen rein beispielhaft näher beschrieben, wobei auch auf weitere Vorteile der Erfindung eingegangen wird. Hierbei wird zum Teil auf Bezugszeichen bereits zuvor erläuterter Figuren zurückgegriffen. Im Einzelnen zeigen:
- Fig. 1: die Anordnung eines Bauteils oberhalb eines von einem ringförmigen Aussparungsbereich umgebenen Befestigungsabschnitts einer Trägerplatte vor Herstellen der Lötverbindung in einer Schrägansicht;
- Fig. 2: eine Trägerplatte mit drei von unterschiedlichen ringförmigen Aussparungsbereichen umgebenen Befestigungsabschnitten;
- Fig. 3a, 3b: die Anordnung eines Bauteils vor (Fig. 3a) und nach (Fig. 3b) dem Herstellen der Lötverbindung in einer Querschnittsansicht; und
- Fig. 4a bis 4d: die Anordnung eines Bauteils mit einer hohlzylindrischen Basis, das Ausrichten eines Lötmaterialflachstücks und des Bauteils sowie das Herstellen der Lötverbindung in einer Querschnittsansicht.

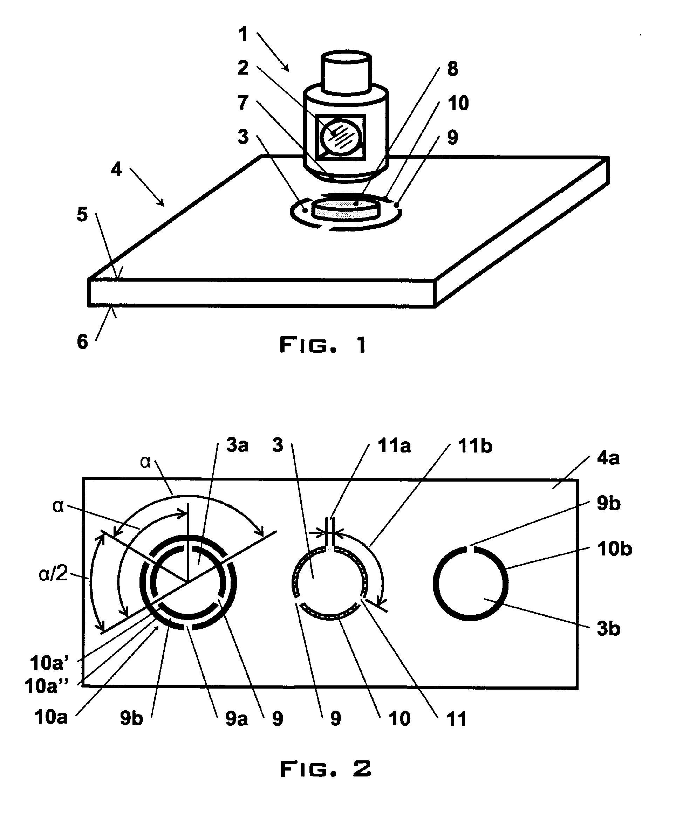

In Fig. 1 ist ein ebene Trägerplatte 4 aus Metall dargestellt, in deren Mitte ein Befestigungsabschnitt 3 geformt ist, der von einem ringförmigen Aussparungsbereich 10 umschlossen ist, der sich aus drei bogensegmentförmigen, vertikal die Trägerplatte 4 von deren Oberseite 5 zu deren Unterseite 6 durchlaufenden Schlitzen zusammensetzt, die jeweils von einem Verbindungssteg 9 getrennt sind. Die drei Verbindungsstege 9 koppeln den Befestigungsabschnitt 3 mechanisch mit der restlichen Trägerplatte 4 und verlaufen radial zum horizontalen Zentrum des ringförmigen Aussparungsbereichs 10. Die Trägerplatte 4, deren Befestigungsabschnitt 3 und deren drei Verbindungsstege 9 sind einstückig aus Metall ausgebildet. Auf der Oberseite 5 des Befestigungsabschnitts 3 befindet sich Lötmaterial 8, das die Grundform eines flachen Zylinderstumpfs hat. Oberhalb des Befestigungsabschnitts 3 und des Lötmaterials 8 ist ein Bauteil 1, das ein mikrooptisches Element 2 trägt, derart angeordnet, dass sich das Lötmaterial 8 und die Basis 7 des Bauteils 1 in berührungsfreier, vertikal geringfügig beabstandeter, einen Zwischenraum bildenden Gegenüberlage befinden. Die Basis 7 des Bauteils 1 wird von einem Kugelsegment aus Metall gebildet und weist eine gute Benetzbarkeit für das geschmolzene Lötmaterial auf.

Fig. 2 zeigt eine Trägerplatte 4a, in der drei unterschiedliche Befestigungsabschnitte 3, 3a und 3b ausgeformt sind. Der mittlere Befestigungsabschnitt 3 gleicht demjenigen aus Fig. 1 und wird von dem als kreisförmige Aussparung ausgebildeten Aussparungsbereich 10, der von den drei Verbindungsstegen 9 überbrückt wird, umschlossen. Der kreisförmige mittlere Umfang 11 dieser kreisförmigen Aussparung 10 ist mittels einer Strichpunktlinie dargestellt. Wie klar zu erkennen ist, ist der von den drei Verbindungsstegen 9 überbrückte Anteil 11a des Umfangs 11 wesentlich geringer als der ausgesparte Anteil 11b des Umfangs, im gezeigten Ausführungsbeispiel unter 20%, vorzugsweise unter 15%, insbesondere unter 10%. Hierdurch wird der auf die Verbindungsstege 9 beschränkte Wärmeübergang von dem Befestigungsabschnitt 3 auf die restliche Trägerplatte 4a wesentlich begrenzt. Der rechte Befestigungsabschnitt 3b wird von einer kreisförmigen Aussparung 10b umschlossen, die nur von einem einzigen Verbindungssteg 9b überbrückt wird. Ein Vorteil dieser Ausführungsform ist der noch geringere Wärmeübergang zur restlichen Trägerplatte 4a und die leichte Ausrichtbarkeit des Befestigungsabschnitts 3b relativ zur restlichen Trägerplatte 4a. Der linke Befestigungsabschnitt 3a ist von einem Aussparungsbereich 10a umschlossen, der von zwei konzentrischen, beabstandet angeordneten, ringförmigen Aussparungen 10a' und 10a'' gebildet wird. Jeder dieser zwei ringförmigen Aussparungen 10a' und 10a'' wird von in gleichmässigen Winkelabständen α von 120° verteilten, radial zum Zentrum des Befestigungsabschnitts 3a verlaufenden Verbindungsstegen 9 und 9a überbrückt. Die in Winkelabständen α von 120° verteilten ersten Verbindungsstege 9 der ersten inneren ringförmigen Aussparung 10a' und die in ebenfalls in Winkelabständen α von 120° verteilten zweiten Verbindungsstege 9a der zweiten unmittelbar benachbarten äusseren ringförmigen Aussparung 10a'' sind um den halben Winkelabstand α/2 von 60° versetzt angeordnet. Diese Verbindungsstege 9 und 9a sind wiederum über einen die erste innere ringförmige Aussparung 10a' und die zweite äussere ringförmige Aussparung 10a'' trennenden ringförmigen Verbindungssteg 9b verbunden. Durch diese versetzte Anordnung kann eine laterale Wärmeausdehnung des Befestigungsabschnitts 3a durch Verformung des ringförmigen Verbindungsstegs 9b ausgeglichen werden, ohne dass es zum Aufwölben eines Teils der Trägerplatte 4a kommt, so dass eine erhöhte vertikale Endpositionsgenauigkeit erzielt werden kann.

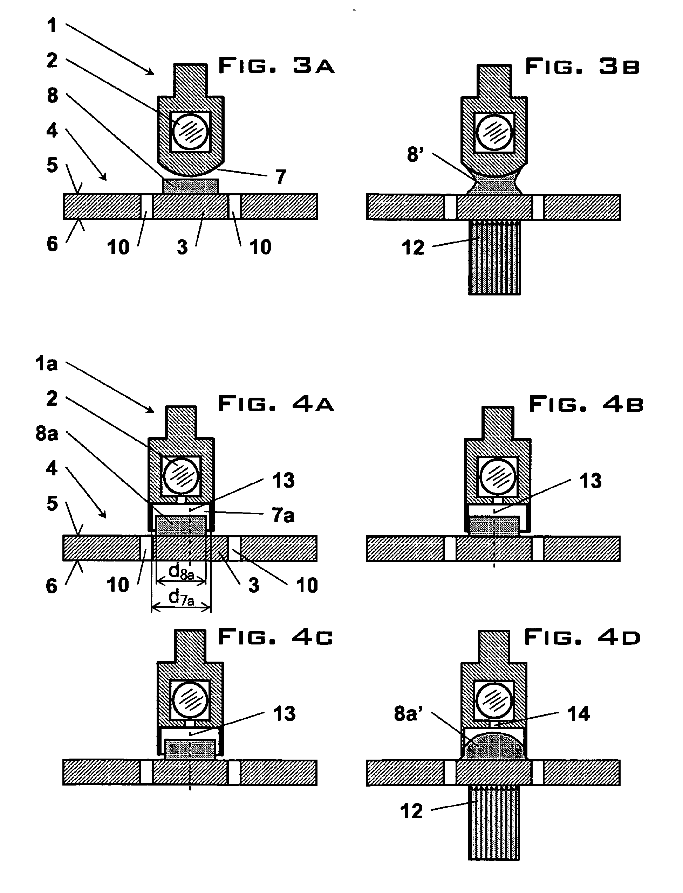

In Fig. 3a und 3b wird die Anordnung des Bauteils 1 aus Fig. 1 vor - siehe Fig. 3a - und nach - siehe Fig. 3b - dem Herstellen einer Lötverbindung in einer Querschnittsansicht gezeigt. Das Bauteil 1 mit dessen mikrooptischen Element 2 ist in Fig. 3a hochpräzise oberhalb des Befestigungsabschnitts 3 angeordnet, wobei sich das Lötmaterial 8 und die Basis 7 des Bauteils 1 in berührungsfreier, vertikal geringfügig beabstandeter, einen Zwischenraum bildenden Gegenüberlage befinden. In Fig. 3b wird das Zuführen von elektromagnetischer Strahlung in Form eines Laserstrahlenbündels 12 in einem lokal, im Wesentlichen auf den Befestigungsabschnitt 3 beschränkten Bereich von der Unterseite 6 der Trägerplatte 4 veranschaulicht. Das Laserstrahlenbündel 12 wird von der Unterseite 6 des Befestigungsabschnitts 3 absorbiert und erhitzt diesen aufgrund der relativ hohen Wärmeleitfähigkeit des Metalls sowohl horizontal als auch vertikal homogen. Durch die lokale Erhitzung des Befestigungsabschnitts 3 wirkt dieser wie eine Herdplatte und bringt das Lötmaterial 8 zum Schmelzen. Aufgrund der Oberflächenspannung kommt es zur Tropfenbildung des geschmolzenen Lötmaterials 8'. Optional wird zusätzlich der vertikale Abstand des Bauteils 1 zu der Trägerplatte 4 durch Absenken des Bauteils 1 von einer Ausgangsposition in Richtung zur Trägerplatte 4 verringert. Durch die Tropfenbildung und gegebenenfalls durch das Absenken des Bauteils 1 füllt sich der Zwischenraum zur gegenseitigen Befestigung mit geschmolzenem Lötmaterial 8'. Hierdurch wird die Basis 7 des Bauteils 1 mit dem geschmolzenen Lötmaterial 8' benetzt. Nach Abstellen des Laserstrahlenbündels 12 wird auf die gegenseitige Befestigung durch Wiedererstarren des geschmolzenen Lötmaterials 8' gewartet.

Fig. 4a bis 4d zeigen eine weitere Ausführungsform des erfindungsgemässen Verfahrens. Auf der Oberseite 5 des Befestigungsabschnitts 3 der Trägerplatte 4 befindet sich ein Lötmaterial in Form eines Lötmaterialflachstücks 8a, das die Grundform eines flachen Zylinderstumpfs mit einem Lötmaterialaussendurchmesser d₈ₐ hat. Das Lötmaterialflachstück 8a ist lose aufgelegt und somit auf dem Befestigungsabschnitt 3 horizontal verschiebbar. Die Basis 7a des Bauteils 1a besitzt die Form eines nach unten offenen Hohlzylinders mit einem Hohlzylinderinnendurchmesser d₇ₐ. Der Lötmaterialaussendurchmesser d₈ₐ ist kleiner als der Hohlzylinderinnendurchmesser d₇ₐ. Beispielsweise beträgt d₈ₐ gleich 2,1 mm und d₇ₐ gleich 2,3 mm, wobei das Lötmaterialflachstücks 8a eine Höhe von 0,8 mm und die Trägerplatte eine Dicke von 1,0 mm hat. In einem ersten Schritt, siehe Fig. 4a, wird das Bauteil 1a oberhalb des Befestigungsabschnitts 3 derart angeordnet, dass das Lötmaterialflachstück 8a von der hohlzylindrischen Basis 7a in berührungsfreier, beabstandeter, einen Zwischenraum bildenden Gegenüberlage zumindest teilweise umschlossen wird. Das Lötmaterialflachstück 8a und das Bauteil 1a befindet sich jedoch noch nicht in der horizontalen Sollposition, die durch die als Strichpunktlinie dargestellte Mittellinie 13 angedeutet ist. Da das sich mit Spiel innerhalb der hohlzylindrischen Basis 7a befindliche Lötmaterialflachstück 8a exakt mittig in der hohlzylindrischen Basis 7a angeordnet sein soll, um Asymmetrien, die sich vor allem auf die vertikale Endpositionsgenauigkeit auswirken, zu vermeiden, wird zunächst das Lötmaterialflachstück 8a in die mittige Position gebracht. Dies geschieht durch den in Fig. 4b veranschaulichten Schritt des horizontalen Lötmaterial-Feinpositionierens durch Verschieben des eingeschlossenen Lötmaterialflachstücks 8a durch horizontales Vorpositionieren des Bauteils 1a, wobei die hohlzylindrische Basis 7a das umschlossene Lötmaterialflachstück 8a horizontal mitschiebt. In einem nächsten Schritt, siehe Fig. 4c, wird das Bauteil 1a hochpräzise horizontal zur Mittellinie 13 feinpositioniert. Da nun sowohl das Lötmaterialflachstück 8a, als auch das Bauteil 1a exakt zur Mittellinie 13 und somit zur horizontalen Sollposition ausgerichtet sind, kann in einem nächsten Schritt das bereits oben beschriebene Richten eines Laserstrahlenbündels 12 auf die Unterseite 6 des Befestigungsabschnitts 3 erfolgen. Das geschmolzenen Lötmaterial 8a' benetzt die Innenmantelfläche der dünnwandigen hohlzylindrischen Basis 7a. Ein Vorteil der Ausgestaltung der Basis 7a besteht darin, dass das geschmolzene Lötmaterial 8a' vertikal nach oben tendieren kann, ohne zwangsläufig das Bauteil 1a vertikal zu verschieben. Überdies wird die Wärmeleitung des Lötmaterials 8a' auf den oberen Abschnitt des Bauteils 1a, auf welchem das eventuell thermisch hoch empfindliche mikrooptische Element 2 angeordnet ist, sehr gering gehalten. Um Spannungen durch in der hohlzylindrischen Basis 7a eingeschlossene Luft zu verhindern, ist ein Kanal 14 vorgesehen, der ein Entweichen der Luft und eine zusätzliche Wärmeabfuhr ermöglicht. In einem nächsten, nicht dargestellten Schritt wird auf das Erstarren des Lötmaterials 8a' und die gegenseitige Befestigung gewartet.

Selbstverständlich ist es möglich, das erfindungsgemässe Verfahren um bereits bekannte zusätzliche Verfahrensschritte, die insbesondere das Positionieren des Bauteils mittels eines Greifers betreffen, zu erweitern.

## Patentansprüche

1. Verfahren zur hochpräzisen Befestigung eines miniaturisierten Bauteils (1; 1a), insbesondere mit einem mikrooptischen Element (2), auf einem vorgegebenen Befestigungsabschnitt (3; 3a; 3b) einer Trägerplatte (4; 4a) durch eine Lötverbindung, wobei
• die Trägerplatte (4; 4a) eine Oberseite (5) aus einem metallischen Werkstoff und eine Unterseite (6) sowie das Bauteil (1; 1a) eine Basis (7; 7a) aufweist und
• Lötmaterial (8; 8a) zumindest teilweise auf der Oberseite des Befestigungsabschnitts (3; 3a; 3b) der Trägerplatte (4; 4a) aufgebracht ist,
mit den Schritten
• hochpräzises Anordnen des Bauteils (1; 1a) oberhalb des Befestigungsabschnitts (3; 3a; 3b), wobei sich das Lötmaterial (8; 8a) und die Basis (7; 7a) des Bauteils (1; 1a) in berührungsfreier, beabstandeter, einen Zwischenraum bildenden Gegenüberlage befinden,
• Zuführen von elektromagnetischer Strahlung (12) in einem lokal, im Wesentlichen auf den Befestigungsabschnitt (3; 3a; 3b) beschränkten Bereich von der Unterseite (6) der Trägerplatte (4; 4a) zum zumindest teilweisen, eine Tropfenbildung bewirkenden Schmelzen des Lötmaterials (8'; 8a') und gegebenenfalls Verringern des vertikalen Abstands des Bauteils (1; 1a) zu der Trägerplatte (4; 4a) durch Absenken des Bauteils (1; 1a) von einer Ausgangsposition in Richtung zur Trägerplatte (4; 4a), so dass sich durch die Tropfenbildung und gegebenenfalls durch das Absenken des Bauteils (1; 1a) der Zwischenraum zur gegenseitigen Befestigung mit geschmolzenem Lötmaterial (8'; 8a') füllt und die Basis (7; 7a) des Bauteils (1; 1a) zumindest teilweise benetzt wird, und
• Warten auf die gegenseitige Befestigung durch Wiedererstarren des geschmolzenen Lötmaterials (8'; 8a'),
**dadurch gekennzeichnet, dass** die Trägerplatte (4; 4a)
• durchgängig aus einem metallischen Werkstoff, insbesondere einer Legierung oder einem metallischen Keramikwerkstoff, ausgebildet ist und
• einen den Befestigungsabschnitt (3; 3a; 3b) umschliessenden, von mindestens einem Verbindungssteg (9; 9a; 9b) der Trägerplatte (4; 4a) überbrückten Aussparungsbereich (10; 10a; 10b) aufweist.

2. Verfahren nach Anspruch 1, wobei
der Befestigungsabschnitt (3; 3a; 3b) derart dimensioniert und ausgestaltet ist, dass ein einziges Bauteil (1; 1a) auf dem Befestigungsabschnitt (3; 3a; 3b) befestigbar ist.

3. Verfahren nach Anspruch 1 oder 2, wobei
der Aussparungsbereich als mindestens eine im Wesentlichen ringförmige Aussparung (10; 10a; 10b) ausgebildet ist, die von dem mindestens einen Verbindungssteg (9; 9a; 9b) überbrückt ist.

4. Verfahren nach Anspruch 3, wobei
die ringförmige Aussparung (10; 10a) von mehreren entlang der ringförmigen Aussparung (10; 10a) in gleichmässigen Winkelabständen (α) verteilten, radial verlaufenden Verbindungsstegen (9; 9a) überbrückt ist.

5. Verfahren nach Anspruch 4, wobei
die ringförmige Aussparung (10; 10a) von drei entlang der ringförmigen Aussparung in gleichmässigen Winkelabständen (α) von 120° verteilten, radial verlaufenden Verbindungsstegen (9; 9a) überbrückt ist.

6. Verfahren nach Anspruch 4 oder 5, wobei
der Aussparungsbereich (10a) von mehreren konzentrischen, beabstandet angeordneten, ringförmigen Aussparungen (10a', 10a'') gebildet wird.

7. Verfahren nach Anspruch 6, wobei
• die in gleichmässigen Winkelabständen (α) verteilten ersten Verbindungsstege (9) einer ersten ringförmigen Aussparung (10a') und
• die in den gleichmässigen Winkelabständen (α) verteilten zweiten Verbindungsstege (9a) einer zweiten unmittelbar benachbarten ringförmigen Aussparung (10a")
um den halben Winkelabstand (α/2) versetzt angeordnet und über einen die erste ringförmige Aussparung (10a') und die zweite ringförmige Aussparung (10a") trennenden ringförmigen Verbindungssteg (9b) verbunden sind, so dass eine laterale Wärmeausdehnung des Befestigungsabschnitts (3a) durch Verformung des ringförmigen Verbindungsstegs (9b) ausgleichbar ist.

8. Verfahren nach einem der Ansprüche 1 bis 7, wobei
der Aussparungsbereich (10; 10a; 10b) derart ausgebildet ist, dass entlang dem mittleren - insbesondere kreisförmigen - Umfang (11) des Aussparungsbereichs (10; 10a; 10b) der von dem mindestens einen Verbindungssteg (9; 9a; 9b) der Trägerplatte (4; 4a) überbrückte Anteil (11a) wesentlich geringer als der ausgesparte Anteil (11b) ist.

9. Verfahren nach Anspruch 8, wobei
der überbrückte Anteil (11a) weniger als 20%, insbesondere weniger als 15%, beträgt.

10. Verfahren nach einem der Ansprüche 1 bis 9, wobei
die Trägerplatte (4; 4a) durchgängig aus Stahl ausgebildet ist.

11. Verfahren nach einem der Ansprüche 1 bis 9, wobei
die Trägerplatte (4; 4a) durchgängig aus einem metallischen Keramikwerkstoff ausgebildet ist.

12. Verfahren nach einem der Ansprüche 1 bis 11, wobei
• die elektromagnetische Strahlung von einem Laserstrahlenbündel (12) gebildet wird und
• das Zuführen der elektromagnetischer Strahlung lokal begrenzt durch Richten des Laserstrahlenbündels (12) auf die Unterseite des Befestigungsabschnitts (3; 3a; 3b) derart erfolgt, dass das Laserstrahlenbündel (12) von der Unterseite des Befestigungsabschnitts (3; 3a; 3b) im Wesentlichen absorbiert wird und den Befestigungsabschnitt (3; 3a; 3b) derart erhitzt, dass das Lötmaterial (8; 8a) auf der Oberseite des Befestigungsabschnitts (3; 3a; 3b) zumindest teilweise schmilzt.

13. Verfahren nach Anspruch 12, wobei
die Unterseite zumindest des Befestigungsabschnitts (3; 3a; 3b) zur Erhöhung der Absorption des Laserstrahlenbündels (12) geschwärzt ist.

14. Verfahren nach einem der Ansprüche 1 bis 13, wobei
• das auf der Oberseite des Befestigungsabschnitts (3) aufgebrachte, noch nicht geschmolzene Lötmaterial als ein Lötmaterialflachstück (8a), das die Grundform eines flachen Zylinderstumpfs mit einem Lötmaterialaussendurchmesser (d₈ₐ) aufweist, ausgebildet und auf dem Befestigungsabschnitt (3) horizontal verschiebbar angeordnet ist,
• die Basis (7a) des Bauteils (1a) die Form eines nach unten offenen Hohlzylinders mit einem Hohlzylinderinnendurchmesser (d₇ₐ) aufweist,
• der Lötmaterialaussendurchmesser (d₈ₐ) kleiner als der Hohlzylinderinnendurchmesser (d₇ₐ) ist und
• der Schritt des Anordnens des Bauteils (1a) folgende Teilschritte umfasst:
□ Anordnen des Bauteils (1a) oberhalb des Befestigungsabschnitts (3), wobei das Lötmaterial (8a) von der hohlzylindrischen Basis (7a) in berührungsfreier, beabstandeter, einen Zwischenraum bildenden Gegenüberlage zumindest teilweise umschlossen wird, und
□ hochpräzises horizontales Feinpositionieren des Bauteils (1a), wobei die hohlzylindrische Basis (7a) das umschlossene Lötmaterialflachstück (8a) horizontal mitschiebt.

15. Verfahren nach Anspruch 14, wobei der Teilschritt des hochpräzisen horizontalen Feinpositionierens folgende Teilschritte umfasst:
□ horizontales Lötmaterial-Feinpositionieren durch Verschieben des eingeschlossenen Lötmaterialflachstücks (8a) durch horizontales Vorpositionieren des Bauteils (1a), wobei die hohlzylindrische Basis (7a) das umschlossene Lötmaterialflachstück (8a) horizontal mitschiebt, und
□ hochpräzises horizontales Feinpositionieren des Bauteils (1a).

16. Verfahren nach einem der Ansprüche 1 bis 15, mit dem weiteren Schritt:
• zumindest teilweises Auffüllen des Aussparungsbereichs (10; 10a; 10b) mit einem flüssigen, erstarrenden Füllmaterial zum zumindest teilweisen Überbrücken des nicht von dem mindestens einen Verbindungssteg (9; 9a; 9b) überbrückten Aussparungsbereichs (10; 10a; 10b).

## Claims

1. Method for high-precision fixing of a miniaturised component (1; 1a), in particular comprising a microoptical element (2), on a predetermined fixing section (3; 3a; 3b) of a base plate (4; 4a) by a solder joint,
• the base plate (4; 4a) having a top (5) comprising a metallic material and a bottom (6) and the component (1; 1a) having a base (7; 7a) and
• solder material (8; 8a) being applied at least partly on the top of the fixing section (3; 3a; 3b) of the base plate (4; 4a)
comprising the steps
• high-precision arrangement of the component (1; 1a) above the fixing section (3; 3a; 3b), the solder material (8; 8a) and the base (7; 7a) of the component (1; 1a) being present in opposite positions without contact, a distance apart and forming a space,
• supply of electromagnetic radiation (12) in a localised region of the bottom (6) of the base plate (4; 4a), which is limited substantially to the fixing section (3; 3a; 3b), for at least partial melting of the solder material (8'; 8a') with drop formation and optionally reduction of the vertical distance of the component (1; 1a) from the base plate (4; 4a) by lowering of the component (1; 1a) from a starting position towards the base plate (4; 4a), so that, as a result of the drop formation and optionally by the lowering of the component (1; 1a), the space is filled with molten solder material (8'; 8a') for mutual fixing and the base (7; 7a) of the component (1; 1a) is at least partly wetted, and
• waiting for the mutual fixing by resolidification of the molten solder material (8'; 8a'),
**characterized in that** the base plate (4; 4a)
• is formed throughout from a metallic material, in particular an alloy or a metallic ceramic material,
• has a cut-out region (10; 10a; 10b) enclosing the fixing section (3; 3a; 3b) and bridged by at least one connecting web (9; 9a; 9b) of the base plate (4; 4a).

2. Method according to Claim 1, wherein the fixing section (3; 3a; 3b) is dimensioned and designed in such a way that a single component (1; 1a) can be fixed on the fixing section (3; 3a; 3b).

3. Method according to Claim 1 or 2, wherein the cut-out region is in the form of at least one substantially annular cut-out (10; 10a; 10b) which is bridged by the at least one connecting web (9; 9a; 9b).

4. Method according to Claim 3, wherein the annular cut-out (10; 10a) is bridged by a plurality of radial connecting webs (9; 9a) distributed at uniform angular spacings (α) along the annular cut-out (10; 10a).

5. Method according to Claim 4, wherein the annular cut-out (10; 10a) is bridged by three radial connecting webs (9; 9a) distributed at uniform angular spacings (α) of 120° along the annular cut-out.

6. Method according to Claim 4 or 5, wherein the cut-out region (10a) is formed by a plurality of concentric, annular cut-outs (10a', 10a") arranged a distance apart.

7. Method according to Claim 6, wherein
• the first connecting webs (9) of a first annular cut-out (10a') which are distributed at uniform angular spacings (α) and
• the second connecting webs (9a) of a second directly adjacent annular cut-out (10a'') which are distributed at the uniform angular spacings (ά)
are arranged offset by half the angular spacing (α/2) and are connected via an annular connecting web (9b) separating the first annular cut-out (10a') and the second annular cut-out (10a''), so that a lateral thermal expansion of the fixing section (3a) can be compensated by deformation of the annular connecting web (9b).

8. Method according to any of Claims 1 to 7, wherein the cut-out region (10; 10a; 10b) is formed in such a way that, along the middle - in particular circular - circumference (11) of the cut-out region (10; 10a; 10b), the portion (11a) bridged by the at least one connecting web (9; 9a; 9b) of the base plate (4; 4a) is substantially smaller than the cut-out portion (11b).

9. Method according to Claim 8, wherein the bridged portion (11a) is less than 20%, in particular less than 15%.

10. Method according to any of Claims 1 to 9, wherein the base plate (4; 4a) is formed from steel throughout.

11. Method according to any of Claims 1 to 9, wherein the base plate (4; 4a) is formed from metallic ceramic material throughout.

12. Method according to any of Claims 1 to 11, wherein
• the electromagnetic radiation is formed by a laser beam (12) and
• the supply of the electromagnetic radiation is localised by directing the laser beam (12) onto the bottom of the fixing section (3; 3a; 3b) in such a way that the laser beam (12) is substantially absorbed by the bottom of the fixing section (3; 3a; 3b) and heats the fixing section (3; 3a; 3b) so that the solder material (8; 8a) on the top of the fixing section (3; 3a; 3b) at least partly melts.

13. Method according to Claim 12, wherein the bottom of at least the fixing section (3; 3a; 3b) is blackened in order to increase the absorption of the laser beam (12).

14. Method according to any of Claims 1 to 13, wherein
• solder material which has been applied to the top of the fixing section (3) and has still not melted is in the form of a flat solder material piece (8a) which has the basic shape of a shallow truncated cylinder having an external solder material diameter (d₈ₐ) and is arranged so as to be horizontally displaceable on the fixing section (3),
• the base (7a) of the component (1a) has the shape of a hollow cylinder which is open at the bottom and has an internal diameter (d₇ₐ) of the hollow cylinder,
• the external solder material diameter (d₈ₐ) is smaller than the internal diameter d₇ₐ) of the hollow cylinder and
• the step of arranging the component (1a) comprises the following partial steps:
o arrangement of the component (1a) above the fixing section (3), the solder material (8a) being at least partly enclosed by the hollow cylindrical base (7a) in opposite positions without contact, a distance apart and forming a space, and
o high-precision horizontal fine positioning of the component (1a), the hollow cylindrical base (7a) horizontally displacing the enclosed flat solder material piece (8a).

15. Method according to Claim 14, wherein the partial step of high-precision horizontal fine positioning comprises the following partial steps:
o horizontal fine positioning of the solder material by displacement of the enclosed flat solder material piece (8a) by horizontal prepositioning of the component (1a), the hollow cylindrical base (7a) horizontally displacing the enclosed flat solder material piece (8a), and
o high-precision horizontal fine positioning of the component (1a).

16. Method according to any of Claims 1 to 15, comprising the further step:
• at least partial filling of the cut-out region (10; 10a; 10b) with a liquid, solidifying filling material for at least partial bridging of the cut-out region (10; 10a; 10b) not bridged by the at least one connecting web (9; 9a; 9b).

## Revendications

1. Procédé de fixation à haute précision d'un composant (1; 1a) miniaturisé, en particulier avec un élément (2) micro-optique, sur un tronçon de fixation (3 ; 3a ; 3b) prédéterminé d'une plaque support (4 ; 4a), au moyen d'une liaison par brasage, où
• la plaque support (4 ; 4a) présente une face supérieure (5) formée d'un matériau métallique et une face inférieure (6) et le composant (1 ; 1a) présente une base (7 ; 7a), et
• le matériau de brasage (8 ; 8a) est appliqué au moins partiellement sur la face supérieure du tronçon de fixation (3 ; 3a ; 3b) de la plaque support (4 ; 4a),
avec les étapes ci-après
• agencement de haute précision du composant (1 ; 1a) au-dessus du tronçon de fixation (3 ; 3a ; 3b), le matériau de brasage (8 ; 8a) et la base (7 ; 7a) du composant (1; 1a) se trouvant en confrontation sans contact, espacée, formant un espace intermédiaire,
• amenée d'un rayonnement (12) électromagnétique dans une zone limitée, localement, essentiellement au tronçon de fixation (3 ; 3a ; 3b), depuis la face inférieure (6) de la plaque support (4 ; 4a), pour obtenir la mise en fusion au moins partielle, provoquant une formation de gouttes, du matériau de brasage (8' ; 8a') et, le cas échéant, la diminution de l'espacement vertical du composant (1 ; 1a) par rapport à la plaque support (4 ; 4a) par abaissement du composant (1 ; 1a), depuis une position initiale, dans la direction allant à la plaque support (4 ; 4a),
de manière que, du fait de la formation de gouttes et, le cas échéant, du fait de l'abaissement du composant (1 ; 1a), l'espace intermédiaire se remplisse de matériau de brasage (8 ; 8a) fondu pour entraîner la fixation mutuel, et la base (7 ; 7a) du composant (1 ; 1a) étant au moins partiellement mouillée, et
• attente de la fixation mutuelle par resolidification du matériau de brasage (8' ; 8a') fondu,
**caractérisé en ce que** la plaque support (4 ; 4a)
• est réalisée continûment en un matériau métallique, en particulier en un alliage ou un matériau céramique métallique, et
• présente une zone d'évidement (10 ; 10a ; 10b) entourant le tronçon de fixation (3 ; 3a ; 3b), pontée par au moins une nervure de liaison (9 ; 9a ; 9b) de la plaque support (4 ; 4a).

2. Procédé selon la revendication 1, le tronçon de fixation (3 ; 3a ; 3b) étant dimensionné et configuré de manière qu'un composant (1 ; 1a) unique soit susceptible d'être fixé sur le tronçon de fixation (3 ; 3a ; 3b).

3. Procédé selon la revendication 1 ou 2, où
la zone d'évidement est réalisée sous la forme d'au moins un évidement (10; 10a ; 10b) sensiblement en forme d'anneau, ponté par la au moins une nervure de liaison (9 ; 9a ; 9b).

4. Procédé selon la revendication 3, où
l'évidement (10 ; 10a) en forme d'anneau est ponté par une pluralité de nervures de liaison (9 ; 9a) s'étendant radialement, réparties, selon des espacements angulaires (α) réguliers, le long de l'évidement (10 ; 10a) en forme d'anneau.

5. Procédé selon la revendication 4, où
l'évidement (10 ; 10a) en forme d'anneau est ponté par trois nervures de liaison (9 ; 9a) s'étendant radialement, réparties selon des espacements angulaires (α) réguliers de 120°, le long de l'évidement en forme d'anneau.

6. Procédé selon la revendication 4 ou 5, où
la zone d'évidement (10a) est formée par une pluralité d'évidements (10a', 10a") en forme d'anneau, concentriques, disposés de façon espacée.

7. Procédé selon la revendication 6, où
• les premières nervures de liaison (9), réparties selon des espacements angulaires (α) réguliers, d'un premier évidement (10a') en forme d'anneau, et
• les deuxièmes nervures de liaison (9a) réparties selon les espacements angulaires (α) réguliers, d'un deuxième évidement (10a") en forme d'anneau directement voisin,
sont disposées de façon décalée de la moitié de l'espacement angulaire (α/2) et sont reliées, par l'intermédiaire d'une nervure de liaison (9b) en forme d'anneau, séparant le premier évidement (10a') en forme d'anneau et le deuxième évidement (10a") en forme d'anneau, de manière qu'une dilatation thermique latérale du tronçon de fixation (3a) puisse être compensée par une déformation de la nervure de liaison (9b) en forme d'anneau.

8. Procédé selon l'une des revendications 1 à 7, la zone d'évidement (10 ; 10a ; 10b) étant réalisée de manière que, le long de la périphérie (11) médiane - en particulier, en forme d'anneau - de la zone d'évidement (10 ; 10a ; 10b), la proportion (11a), pontée par la au moins une nervure de liaison (9 ; 9a ; 9b) de la plaque support (4 ; 4a), soit notablement inférieure à la proportion (11b) évidée.

9. Procédé selon la revendication 8, où
la proportion (11a) pontée est inférieure à 20 %, en particulier inférieure à 15 %.

10. Procédé selon l'une des revendications 1 à 9, la plaque support (4 ; 4a) étant réalisée continûment en acier.

11. Procédé selon l'une des revendications 1 à 9, la plaque support (4 ; 4a) étant réalisée continûment en un matériau céramique, métallique.

12. Procédé selon l'une des revendications 1 à 11, où
• le rayonnement électromagnétique est formé par un faisceau de rayon laser (12, et
• l'amenée du rayonnement électromagnétique est limitée localement par guidage du faisceau de rayon laser (12) sur la face inférieure du tronçon de fixation (3 ; 3a ; 3b), de manière que le faisceau de rayon laser (12) soit notablement absorbé par la face inférieure du tronçon de fixation (3 ; 3a ; 3b) et chauffe le tronçon de fixation (3 ; 3a ; 3b), de manière que le matériau de brasage (8 ; 8a), se trouvant sur la face supérieure du tronçon de fixation (3 ; 3a ; 3b), fonde au moins partiellement.

13. Procédé selon la revendication 12, où
la face inférieure, au moins du tronçon de fixation (3 ; 3a ; 3b), est noircie afin d'augmenter l'absorption du faisceau de rayon laser (12).

14. Procédé selon l'une des revendications 1 à 13, où
• le matériau de brasage non encore fondu, appliqué sur la face supérieure du tronçon de fixation (3), est réalisé en tant qu'élément plat en matériau de brasage (8a), présentant la forme de base d'un tronc de cylindre plat avec un diamètre extérieur de matériau de brasage (d₈ₐ), et est disposé de façon déplaçable horizontalement sur le tronçon de fixation (3),
• la base de données (7a) du composant (1a) présente la forme d'un cylindre creux ouvert vers le bas avec un diamètre intérieur de cylindre creux (d₇ₐ),
• le diamètre extérieur de matériau de brasage (d₈ₐ), est inférieur au diamètre intérieur de cylindre creux (d₇ₐ), et
• l'étape d'agencement du composant (1a) comprend les étapes partielles suivantes :
□ agencement du composant (1a) au-dessus du tronçon de fixation (3), le matériau de brasage (8a) étant entouré au moins partiellement par la base (7a) cylindrique creuse, en une confrontation sans contact, espacée, formant un espace intermédiaire, et entraîne
□ positionnement fin horizontal, hautement précis, du composant (1a), la base (7a) cylindrique creuse décalant conjointement horizontalement l'élément plat en matériau de brasage (8a) entouré.

15. Procédé selon la revendication 14, l'étape partielle de positionnement fin horizontal hautement précis comprenant les étapes partielles suivantes :
□ positionnement fin horizontal du matériau de brasage, par déplacement de l'élément plat en matériau de brasage (8a) inclus, par un prépositionnement horizontal du composant (1a), la base de données (7a) cylindrique creuse, déplaçant conjointement horizontalement l'élément plat en matériau de brasage (8a) entouré, et
□ positionnement fin horizontal hautement précis du composant (1a).

16. Procédé selon l'une des revendications 1 à 15, comprenant l'étape supplémentaire suivante :
• remplissage au moins partiel de la zone d'évidement (10 ; 10a ; 10b) avec un matériau de remplissage se solidifiant, liquide, pour ponter au moins partiellement la zone d'évidement (10 ; 10a ; 10b), non pontée par la au moins une nervure de liaison (9 ; 9a ; 9b).
